# EUROPEAN PATENT APPLICATION

(11) **EP 4 768 929 A1**
(43) Date of publication of application: **01.07.2026**
(21) Application number: 25772271.0
(22) Date of filing: 14.02.2025
(51) Int. Cl.: G01R 31/327, G01R 31/52, G01R 19/10, G01R 1/30

(54) **BATTERY DIAGNOSIS DEVICE AND OPERATION METHOD THEREOF**

(30) Priority: 12.03.2024 KR 20240034540
(71) Applicant: LG Energy Solution, Ltd., Seoul 07335 (KR)
(72) Inventor: MOON, Cheoul Woo, Daejeon 34122 (KR)
(74) Representative: Plasseraud IP
(86) International application number: PCT/KR2025/099396
(87) International publication number: WO 2025/193025

(57) **Abstract**

A battery diagnostic device according to an embodiment disclosed herein includes a transistor electrically connected to a first charge/discharge line of a battery pack through a first terminal and electrically connected to a second charge/discharge line of the battery pack through a second terminal, a plurality of base resistors electrically connected to the transistor, the first charge/discharge line and the second charge/discharge line, a switching unit connected to at least one of the first charge/discharge line or the second charge/discharge line and disposed on a low side, and a diagnostic unit connected to the switching unit to diagnose a short-circuit failure of the switching unit based on a voltage difference across the switching unit.

## Description

### TECHNICAL FIELD

### Cross-reference to Related Applications

This application claims priority from Korean Patent Application 10-2024-0034540, filed on March 12, 2024, the disclosure of which is incorporated by reference herein.

### Technical Field

Embodiments disclosed herein relates to a battery diagnostic device and a method of operating the same.

### BACKGROUND ART

In recent years, as the demand for portable electronic products such as laptops, video cameras, and mobile phones rapidly increases and the development of electric vehicles, energy storage batteries, robots, satellites, and the like begins in earnest, research on high-performance batteries capable of repeated charging and discharging is actively being conducted.

Currently commercialized batteries include nickel cadmium batteries, nickel hydrogen batteries, nickel zinc batteries, lithium batteries, and the like, and among these, the lithium batteries have almost no memory effect compared to nickel-based batteries, so that they are receiving attention for advantages of free charging and discharging, a very low self-discharge rate, and a high energy density.

Battery packs are used in various fields, often requiring large capacities, such as electric vehicles or smart grid systems. In order to increase the capacity of a battery pack, there may be a way to increase the capacity of a secondary battery, that is, a battery cell itself, but, in this case, there is a disadvantage in that the capacity increase effect is not large and there is a physical limit on expanding the size of the secondary battery. Therefore, commonly, a battery pack with multiple battery modules connected in series and parallel is widely used.

The battery pack often includes a battery management system (BMS) that manages the battery modules. Furthermore, the BMS monitors the temperature, voltage, current, and the like of the battery modules, and controls the balancing operation, cooling operation, charging operation, discharging operation of the battery pack, or the like based on the state of the monitored battery modules.

In particular, a significant number of battery packs may operate by receiving power from the battery modules contained in their own battery packs. However, in this configuration, due to the current consumption of the BMS, even though a value thereof is small, a situation in which the battery pack is over-discharged or fully discharged may occur. In this case, a problem may occur where power is not normally supplied from the battery pack to loads. In order to solve the problems, a technology to wake up the BMS only when necessary has been suggested.

### DISCLOSURE OF THE INVENTION

### TECHNICAL PROBLEM

One object of the embodiments disclosed herein is to provide a battery diagnostic device that turns on a BMS when a charger is connected from the outside.

One object of the embodiments disclosed herein is to provide a battery diagnostic device that diagnoses a short-circuit failure in a switching unit used to turn on a BMS when a charger is connected from the outside.

The technical problems of the embodiments disclosed herein are not limited to the technical problems mentioned above, and other technical problems not mentioned will be clearly understood by those skilled in the art to which the present invention belongs from the description below.

### TECHNICAL SOLUTION

According to an embodiment disclosed herein, a battery diagnostic device includes a transistor electrically connected to a first charge/discharge line of a battery pack through a first terminal and electrically connected to a second charge/discharge line of the battery pack through a second terminal, a plurality of base resistors electrically connected to the transistor, the first charge/discharge line and the second charge/discharge line, a switching unit connected to at least one of the first charge/discharge line or the second charge/discharge line and disposed on a low side, and a diagnostic unit connected to the switching unit to diagnose a short-circuit failure of the switching unit based on a voltage difference across the switching unit.

According to an embodiment, the switching unit may include a first switch that is a switch for charging and a second switch that is a switch for discharging, and the diagnostic unit may include a first diagnostic unit connected to the first switch to diagnose a short-circuit failure of the first switch and a second diagnostic unit connected to the second switch to diagnose a short-circuit failure of the second switch, voltages at both ends of the second switch being different from each other.

According to an embodiment, the second diagnostic unit may include an insulating element and a differential amplifier, and the insulating element may be turned on when the second switch is diagnosed to electrically connect the switching unit and the differential amplifier.

According to an embodiment, the differential amplifier may be connected to the insulating element and extract a diagnostic voltage by amplifying the voltage difference across the switching unit when the insulating element is turned on.

According to an embodiment, a first terminal of the second switch may be connected to the first switch and a first terminal of the second diagnostic unit, and a second terminal of the second switch may be connected to a charger and a second terminal of the second diagnostic unit.

According to an embodiment, the diagnostic unit may diagnose the switching unit when a state of the switching unit is off.

According to an embodiment, the diagnostic unit may be directly connected to the switching unit and diagnose a short-circuit failure of the switching unit based on a diagnostic voltage defined as a voltage of a connection node between the diagnostic unit and the switching unit.

According to an embodiment, the diagnostic unit may diagnose a short-circuit failure of the switching unit based on a comparison result of the diagnostic voltage and a set value.

According to an embodiment, the set value may be set based on a voltage of the battery pack.

According to an embodiment disclosed herein, a method of operating a battery diagnostic device includes turning off a switching unit connected to at least one of a first charge/discharge line or a second charge/discharge line of a battery pack and disposed on a low side, acquiring a diagnostic voltage based on a voltage difference across the switching unit, and diagnosing a short-circuit failure of the switching unit based on a comparison result of the diagnostic voltage and a set value.

According to an embodiment, the acquiring of the diagnostic voltage may include turning on an insulating element to electrically connect the switching unit and a differential amplifier.

According to an embodiment, the acquiring of the diagnostic voltage may include acquiring the diagnostic voltage by amplifying a voltage difference across the switching unit.

According to an embodiment, the diagnosing may be diagnosing a state of the switching unit as normal when the diagnostic voltage is equal to or higher than the set value, and diagnosing the state of the switching unit as a short-circuit failure when the diagnostic voltage is less than the set value.

According to an embodiment, the set value may be set based on a voltage of the battery pack.

Details of other embodiments are included in the Detailed Description and drawings.

### ADVANTAGEOUS EFFECTS

A battery diagnostic device and a method of operating the same according to the embodiments disclosed herein can turn on a battery management system (BMS) regardless of the potential difference between a battery pack and an external charger when the external charger is connected.

A battery diagnostic device and a method of operating the same according to the embodiments disclosed herein can diagnose a short-circuit failure of a complementary field-effect transistor (C-FET) included in a switching unit.

The effects of the battery diagnostic device and the method of operating the same according to the disclosure herein are not limited to the effects mentioned above, and other effects not mentioned will be clearly understood by those skilled in the art according to the disclosure herein.

### BRIEF DESCRIPTION OF THE DRAWINGS

FIG. 1 is a block diagram showing a battery pack according to an embodiment disclosed herein.
FIG. 2 is a diagram showing a battery diagnostic device according to an embodiment disclosed herein.
FIG. 3 is a drawing showing a switching unit and a diagnostic unit of the battery diagnostic device according to an embodiment disclosed herein.
FIG. 4 is a flowchart showing a method of operating a battery diagnostic device according to an embodiment disclosed herein.
FIG. 5 is a block diagram showing a computing system executing the method of operating a battery diagnostic device according to an embodiment disclosed herein.

With respect to the description of the drawings, the same or similar reference signs may be used for the same or similar elements.

### MODE FOR CARRYING OUT THE INVENTION

Hereinafter, embodiments of the present invention will be described with reference to the accompanying drawings. However, this is not intended to limit the present invention to the specific embodiments, and it is to be construed to include various modifications, equivalents, and/or alternatives of embodiments of the present invention.

It should be appreciated that embodiments of the present disclosure and the terms used therein are not intended to limit the technological features set forth herein to a particular embodiment and include various changes, equivalents, or replacements in corresponding embodiments. With regard to the description of the drawings, similar or related reference numerals may be used to refer to similar or related elements. It is to be understood that a singular form of a noun corresponding to an item may include one or more of the things, unless the relevant context clearly indicates otherwise.

As used herein, each of phrases such as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Terms such as "1st," "2nd," "first," "second," "A," "B," "(a)," or "(b)" may be used to simply distinguish a corresponding component from another, and do not limit the components in other aspects (e.g., importance or order) unless specifically stated otherwise.

In the present specification, it is to be understood that if an element (e.g., a first element) is referred to, with or without the term "operatively" or "communicatively," as "connected to," "coupled to," or "in contact with" another element (e.g., a second element), it means that the element may be connected to the other element directly (e.g., by wire or wirelessly) or indirectly (e.g., via a third element).

A method according to various embodiments disclosed herein may be included in a computer program product and provided. The computer program product may be traded as a product between a seller and a buyer. The computer program product may be distributed in the form of a machine-readable storage medium (e.g., a compact disc read only memory and CD-ROM), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the plurality of entities may be disposed separately from other components. According to embodiments disclosed herein, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as those performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

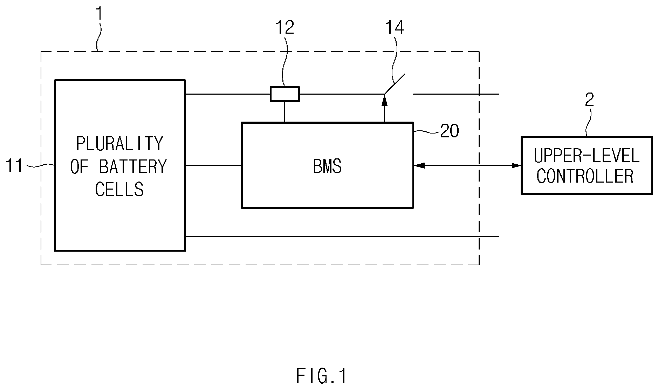

FIG. 1 is a block diagram showing a battery pack according to an embodiment disclosed herein.

Referring to FIG. 1, a battery control system including a battery pack 1 according to an embodiment disclosed herein and an upper-level controller 2 included in an upper-level system is schematically illustrated.

As illustrated in FIG. 1, the battery pack 1 may include one or more battery cells 11, a switching unit 14 for controlling charge and discharge current flow of the battery cells 11 by being connected to a first terminal side and/or a second terminal side of the battery cells 11 in series, and a battery management system 20 for managing the battery pack 1 by monitoring the voltage, current, temperature, and the like of the battery pack 1 to prevent over-charging, over-discharging, or the like.

In this case, the battery pack 1 may be equipped with a plurality of battery cells 11, sensors 12, switching units 14, and battery management systems 20. For example, a first terminal may be a (+) terminal of the battery cell 11, and the second terminal may be a (-) terminal.

Here, the switching unit 14 is a device for controlling the current flow for charging or discharging of the plurality of battery cells 11, and for example, at least one relay, magnetic contactor, or the like, may be used depending on the specifications of the battery pack 1.

The battery management system 20 may be an interface for receiving values obtained by measuring the above-mentioned various parameters, and may include a plurality of terminals, a circuit connected to the terminals to process input values, or the like. In addition, the battery management system 20 may control the ON/OFF of the switching unit 14, for example, a relay, a contactor, or the like, and may be connected to the battery cells 11 to monitor the state of each of the battery cells 11.

The upper-level controller 2 may transmit a control signal for the battery cells 11 to the battery management system 20. Accordingly, the battery management system 20 may be controlled based on the signal received from the upper-level controller 2.

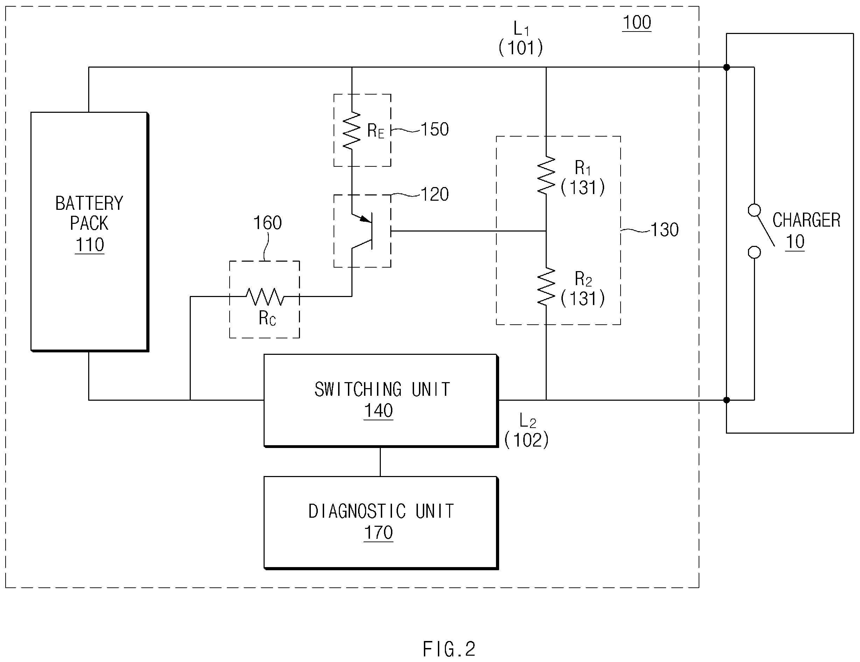

According to the embodiment, the battery management system 20 may include a battery diagnostic device 100 in FIG. 2. In another embodiment, the battery management system 20 may be a system different than the battery diagnostic device 100 in FIG. 2. That is, the battery diagnostic device 100 in FIG. 2 may be included in the battery pack 1 or may be configured as another device external to the battery pack 1. For convenience of description, the following description assumes that the battery diagnostic device 100 is constructed as another device external to the battery pack 1, but the battery diagnostic device is not limited thereto. For example, the operation of the battery diagnostic device 100 below may be performed by the battery management system (BMS) in a vehicle, as well as by various devices such as a server, a cloud, a charger, or a charger/discharger.

FIG. 2 is a diagram showing a battery diagnostic device according to an embodiment disclosed herein.

Referring to FIG. 2, a battery diagnostic device 100 according to an embodiment disclosed herein may include a battery pack 110, a transistor 120, a plurality of base resistors 130, a switching unit 140, an emitter resistor 150, a collector resistor 160, and a diagnostic unit 170.

The battery pack 110 may include one or more battery modules. When the battery pack 110 includes a plurality of battery modules, each battery module may be electrically connected in series and/or in parallel. The battery pack 110 may have its output and/or capacity increased by electrical connection of the battery modules it includes.

Each of one or more battery modules included in the battery pack 110 may include one or more battery cells. The one or more battery cells included in each of the battery modules constituting the battery pack 110 may be electrically connected to each other to increase the output and/or capacity of each battery module.

The battery diagnostic device 100 disclosed herein may be mounted on the vehicle. Therefore, the battery pack 110 may correspond to a vehicle battery pack 110. According to an embodiment, the vehicle may be a vehicle to which driving power for operating is supplied by the battery pack 110. According to an embodiment, the vehicle may correspond to a vehicle that supplies operating power to operate electrical components inside and outside the vehicle. According to an embodiment, the vehicle may be a logistics vehicle without a separate auxiliary power source, such as an autonomous guided vehicle or the like.

The transistor 120 may be connected to the battery pack 110. The transistor 120 may be electrically connected to a first charge/discharge line and a second charge/discharge line of the battery pack 110. According to an embodiment, the first charge/discharge line may be electrically connected to a positive pack terminal of the battery pack 110, and the second charge/discharge line may be electrically connected to a negative pack terminal of the battery pack 110. The transistor 120 may be electrically connected to the first charge/discharge line of the battery pack 110 through the first terminal, and may be electrically connected to the second charge/discharge line through the second terminal.

The transistor 120 may include a bipolar junction transistor 120. Since the transistor 120 is connected to the battery pack 110, current may always flow through the first terminal of the transistor 120. According to an embodiment, the transistor 120 may include a PNP type BJT. The first terminal of the transistor 120 may correspond to an emitter terminal, and the second terminal of the transistor 120 may correspond to a collector terminal. In this case, the current flowing in the first terminal of the transistor 120 may be referred to as an emitter current.

The plurality of base resistors 130 may be electrically connected to the transistor 120, the first charge/discharge line, and the second charge/discharge line. According to an embodiment, the plurality of base resistors 130 may be connected to a base terminal of the transistor 120. According to an embodiment, the plurality of base resistors 130 may include a first resistor 131 and a second resistor 132.

The plurality of base resistors 130 may be branched into the first resistor 131 having one end connected to the transistor 120 and the other end connected to the first charge/discharge line and the second resistor 132 having one end connected to the transistor 120 and the other end connected to the second charge/discharge line. In this case, since a small amount of current flows through the second resistor 132, the transistor 120 may be in a turn-off state.

The switching unit 140 is connected to the battery pack 110, the transistor 120, and the plurality of base resistors 130 to open and close a current path. According to an embodiment, the switching unit 140 may be positioned on the second charge/discharge line of the battery pack 110. In this way, when the switching unit 140 is physically positioned on the second charge/discharge line, it may be said that the switching unit 140 is disposed on the low side.

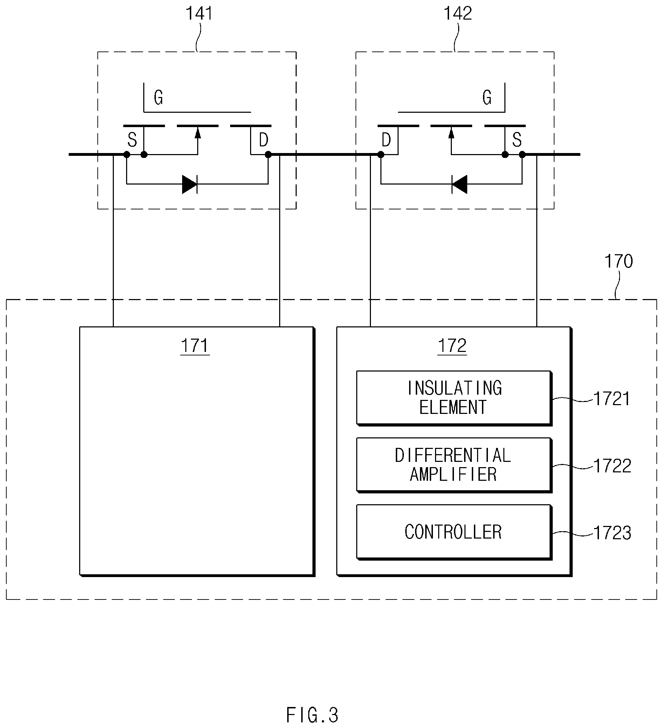

According to an embodiment, the switching unit 140 may be a metal oxide semiconductor field effect transistor (MOSFET) or a relay module. A detailed description of the switching unit 140 is provided below in FIG. 3.

One end of the emitter resistor 150 may be connected to the transistor 120, and the other end may be connected to the first charge/discharge line of the battery pack 110. The emitter resistor 150 may be connected to the emitter terminal of the transistor 120.

One end of the collector resistor 160 may be connected to the transistor 120, and the other end may be connected to the second charge/discharge line of the battery pack 110. The collector resistor 160 may be connected to the collector terminal of the transistor 120.

The diagnostic unit 170 may diagnose the state of the switching unit 140. According to an embodiment, the diagnostic unit 170 may be electrically connected to the switching unit 140, and may diagnose a short-circuit failure of the switching unit 140 based on the voltage of the switching unit 140. For example, the diagnostic unit 170 may compare a voltage difference across the switching unit 140 with a set value, and diagnose a short-circuit failure in the switching unit 140 based on a comparison result. A detailed description of the diagnostic unit 170 is provided below in FIG. 3.

The battery diagnostic device 100 may be connected to an external charger 10. The charger 10 may supply power to the battery diagnostic device 100. The charger 10 may output a fixed voltage, but is not limited thereto, and the charger 10 outputting a variable voltage may be used. According to the embodiment, the charger 10 outputting a variable voltage may output a voltage of a minimum of 20 V and a maximum of 48 V. The charger 10 outputting a variable voltage may output an average voltage of 38 V.

When the battery diagnostic device 100 is not connected to the charger 10, the transistor 120 of the battery diagnostic device 100 may be in the turn-off state. The transistor 120 may correspond to a PNP type BJT, and even when the battery diagnostic device 100 is not connected to the charger 10, current may constantly flow to the emitter terminal of the transistor 120 connected to the battery pack 110. In this case, the current flowing to the emitter terminal may be referred to as an emitter current.

When the battery diagnostic device 100 is connected to the charger 10, the plurality of base resistors 130 may form a closed circuit with the charger 10.

The plurality of base resistors 130 may be branched into the first resistor 131 and the second resistor 132. The plurality of base resistors 130 may be connected to the base terminal of the transistor 120. When the charger 10 is connected, the charger 10 may form a closed circuit with the first resistor 131 and the second resistor 132. In this case, the current flowing through the closed circuit formed by the charger 10, the first resistor 131, and the second resistor 132 may be referred to as a base current. When the base current is formed, since the current is distributed by the first resistor 131 and the second resistor 132, the current flowing to the emitter terminal of the transistor 120 increases, thereby turning on the transistor 120.

Resistance values of the first resistor 131 and the second resistor 132 may be determined to turn on the transistor 120 when the charger 10 is connected to the battery diagnostic device 100. The resistance values of the first resistor 131 and the second resistor 132 may be determined so that the base current formed when the charger 10 is connected to the battery diagnostic device 100 is equal to or greater than a turn-on current provided in a data sheet.

FIG. 3 is a view showing the switching unit 140 and the diagnostic unit 170 of the battery diagnostic device 100 according to an embodiment disclosed herein.

Hereinafter, the switching unit 140 will be specifically described with reference to FIG. 2. The switching unit 140 may be substantially identical to the switching unit 140 in FIG. 2.

The switching unit 140 according to an embodiment disclosed herein may include a plurality of switches. According to the embodiment, each of the plurality of switches may include a MOSFET.

The switching unit 140 may include a first switch 141 and a second switch 142. The switching unit 140 may include the first switch 141 including a first MOSFET and the second switch 142 including a second MOSFET. Here, the first switch 141 may be a switch for charging, and the second switch 142 may be a switch for discharging. According to an embodiment, the first switch 141 and the second switch 142 may be connected in series. Accordingly, a drain of the first switch 141 and a drain of the second switch 142 may be electrically short-circuited with each other. That is, voltages of the drain of the first switch 141 and the drain of the second switch 142 may be the same. In addition, body diodes of the first switch 141 and the second switch 142 may be connected in opposite directions.

According to the embodiment, one end of the first switch 141 may be electrically connected to a first pole of the battery pack 110 and the collector resistor 160. In addition, the other end of the first switch 141 may be electrically connected to the second switch 142. Accordingly, a node voltage of one end of the first switch 141 may be equal to the voltage at the first pole of the battery pack 110. In addition, a voltage at the other end of the first switch 141 may be a value obtained by subtracting a voltage drop caused by the first switch 141 from the voltage at the first pole of the battery pack 110. That is, accordingly, the voltages at one end and the other end of the first switch 141 may be different from each other.

According to the embodiment, one end of the second switch 142 may be electrically connected to the first switch 141. In addition, the other end of the second switch 142 may be electrically connected to the base resistors 130 and the charger 10. That is, one end of the second switch 142 is short-circuited with the other end of the first switch 141, so that the voltage of one end of the second switch 142 may be equal to the voltage of the other end of the first switch 141. In addition, the voltage at the other end of the second switch 142 may be a value obtained by subtracting a voltage drop caused by the charger 10 from the voltage at a second pole of the battery pack 110. In summary, the voltage at one end of the second switch 142 may be a voltage obtained by subtracting the voltage drop caused by the first switch 141 from the voltage at the first pole of the battery pack 110, and the voltage at the other end of the second switch 142 may be a voltage obtained by subtracting the voltage drop caused by the charger 10 from the voltage at the second pole of the battery pack 110. Accordingly, when the second switch 142 is not short-circuited, the voltage at one end of the second switch 142 and the voltage at the other end of the second switch 142 may be different from each other. However, when a short-circuit failure occurs in the second switch 142, the voltage at one end of the second switch 142 and the voltage at the other end of the second switch 142 may be the same.

The diagnostic unit 170 may include a first diagnostic unit 171 and a second diagnostic unit 172. The diagnostic unit 170 may diagnose the state of the switching unit 140 using the first diagnostic unit 171 and the second diagnostic unit 172.

The first diagnostic unit 171 may diagnose the state of the first switch 141. The first diagnostic unit 171 may be connected to the first switch 141. That is, the first diagnostic unit 171 may be connected to each of the source and the drain of the first switch 141. Accordingly, the first diagnostic unit 171 may measure the voltage between the source and the drain of the first switch 141.

According to the embodiment, the first diagnostic unit 171 may diagnose the state of the first switch 141 when the first switch 141 is turned off. For example, the first diagnostic unit 171 may measure the voltage difference across the first switch 141 assuming that the first switch 141 is turned off, and diagnose the state of the first switch 141 based on the voltage difference. That is, the first diagnostic unit 171 may diagnose the state of the first switch 141 as normal when the voltage difference across the first switch 141 is equal to or higher than the first set value. In addition, the first diagnostic unit 171 may diagnose the state of the first switch 141 as a short-circuit failure when the voltage difference across the first switch 141 is less than the first set value.

The second diagnostic unit 172 may diagnose the state of the second switch 142. The second diagnostic unit 172 may be connected to the second switch 142. That is, the second diagnostic unit 172 may be connected to each of the source and the drain of the second switch 142. Accordingly, the second diagnostic unit 172 may measure the voltage between the source and the drain of the second switch 142.

The second diagnostic unit 172 may include an insulating element 1721, a differential amplifier 1722, and a controller 1723. The second diagnostic unit 172 may diagnose the state of the second switch 142 using the insulating element 1721, the differential amplifier 1722, and the controller 1723.

According to the embodiment, the insulating element 1721 may be connected to both ends of the second switch 142. The insulating element 1721 may be a component for insulation between the second switch 142 and the second diagnostic unit 172. That is, the insulating element 1721 may be a component for performing control so that the second switch 142 is not affected by the second diagnostic unit 172.

According to the embodiment, the insulating element 1721 may be turned on or turned off. When the insulating element 1721 is turned on, the insulation is removed, allowing the components connected via the insulating element 1721 to be electrically connected. When the insulating element 1721 is turned off, the electrical connection between the components connected via the insulating element 1721 may be blocked by the insulation.

The differential amplifier 1722 may be connected to the insulating element 1721. That is, the differential amplifier 1722 may be connected to the insulating element 1721 and thus connected to both ends of the second switch 142 via the insulating element 1721. Accordingly, when the insulating element 1721 is turned on, the differential amplifier 1722 may be electrically connected to the second switch 142, and when the insulating element 1721 is turned off, the differential amplifier 1722 may be electrically separated from the second switch 142.

The differential amplifier 1722 may amplify the input voltage. That is, the differential amplifier 1722 may include a first stage and a second stage, and may amplify a difference between a voltage of the first stage and a voltage of the first stage. According to the embodiment, the differential amplifier 1722 may amplify a difference between a voltage at one end of the second switch 142 and a voltage at the other end of the second switch 142. According to the embodiment, a ratio at which the differential amplifier 1722 amplifies the input voltage may be determined depending on the type of the second switch 142.

The controller 1723 may detect the operation of the second switch 142. According to the embodiment, the controller 1723 may detect an on or off state of the second switch 142. The controller 1723 may diagnose the state of the second switch 142 assuming that the state of the second switch 142 is off. According to the embodiment, the controller 1723 may not only detect the operation of the second switch 142, but also control the operation of the second switch 142 itself. That is, the controller 1723 may turn the second switch 142 on or off.

The controller 1723 may control the insulating element 1721. According to the embodiment, the controller 1723 may turn on or off the insulating element 1721. For example, the controller 1723 may turn on the insulating element 1721 when the controller attempts to diagnose the state of the second switch 142. In addition, the controller 1723 may turn off the insulating element 1721 when the controller does not diagnose the state of the second switch 142.

The controller 1723 may acquire a diagnostic voltage. According to the embodiment, the controller 1723 may acquire the diagnostic voltage based on the output voltage of the differential amplifier 1722. That is, the controller 1723 may acquire a voltage by amplifying the voltage across the second switch 142 using the differential amplifier 1722 and define the voltage as the diagnostic voltage.

The controller 1723 may diagnose the state of the second switch 142 based on the diagnostic voltage. The controller 1723 may diagnose the state of the second switch 142 as normal when the diagnostic voltage is equal to or higher than the second set value. In addition, the controller 1723 may diagnose the state of the second switch 142 as a short-circuit failure when the diagnostic voltage is less than the second set value. Here, the second set value may be determined based on at least one of the type of the second switch 142 or the voltage of the battery pack 110.

According to the embodiment, when the state of at least one of the first switch 141 or the second switch 142 is diagnosed as the short-circuit failure, the battery diagnostic device 100 may provide information on a short-circuit failure switching unit 140 to the user. For example, the battery diagnostic device 100 may provide a diagnostic result to a user terminal through a communication unit (not shown), and may also provide the diagnostic result through a display equipped in the vehicle or charger.

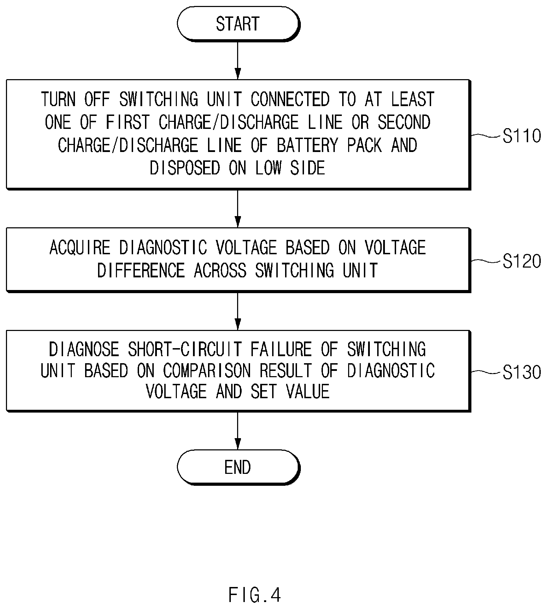

FIG. 4 is a flowchart showing a method of operating a battery diagnostic device 100 according to an embodiment disclosed herein.

The embodiment illustrated in FIG. 4 is only one embodiment, and the order of operations according to various embodiments of the present invention may be different from that shown in FIG. 4, and some of the operations shown in FIG. 4 may be omitted, the order between the steps may be changed, or the steps may be merged.

Referring to FIG. 4, the method of operating the battery diagnostic device 100 may include turning off a switching unit 140 connected to at least one of a first charge/discharge line or a second charge/discharge line of a battery pack 110 and disposed on a low side (S110), acquiring a diagnostic voltage based on a voltage difference across the switching unit 140 (S120), and diagnosing a short-circuit failure of the switching unit 140 based on a comparison result of the diagnostic voltage and a set value (S130).

Hereinafter, the above operations S110 to S130 will be specifically described with reference to FIGS. 1 to 3.

In operation S110, the battery diagnostic device 100 may turn off the switching unit 140 connected to at least one of the first charge/discharge line or the second charge/discharge line of the battery pack 110 and disposed on the low side. According to the embodiment, the battery diagnostic device 100 may diagnose the switching unit 140 assuming turn-off of the switching unit 140. That is, the battery diagnostic device 100 may turn off the first switch 141 and the second switch 142 for diagnosing the first switch 141 and the second switch 142.

In operation S120, a diagnostic voltage may be acquired based on the voltage difference across the switching unit 140. The battery diagnostic device 100 may measure a voltage across the first switch 141 and a voltage across the second switch 142.

According to the embodiment, the battery diagnostic device 100 may control the insulating element 1721. The battery diagnostic device 100 may turn on or off the insulating element 1721. For example, when the battery diagnostic device 100 attempts to diagnose the state of the second switch 142, the battery diagnostic device 100 may turn on the insulating element 1721. In addition, the battery diagnostic device 100 may turn off the insulating element 1721 when the battery diagnostic device 100 does not diagnose the state of the second switch 142.

The battery diagnostic device 100 may acquire a diagnostic voltage. According to the embodiment, the battery diagnostic device 100 may acquire the diagnostic voltage based on the output voltage of the differential amplifier 1722. That is, the battery diagnostic device 100 may acquire a voltage by amplifying the voltage across the second switch 142 using the differential amplifier 1722 and define the voltage as the diagnostic voltage.

In operation S130, a short-circuit failure of the switching unit 140 may be diagnosed based on a comparison result of the diagnostic voltage and a set value.

According to the embodiment, the battery diagnostic device 100 may diagnose the state of the first switch 141 as normal when the voltage difference across the first switch 141 is equal to or higher than a first set value. In addition, the battery diagnostic device 100 may diagnose the state of the first switch 141 as a short-circuit failure when the voltage difference across the first switch 141 is less than the first set value.

According to the embodiment, the battery diagnostic device 100 may diagnose the state of the second switch 142 based on the diagnostic voltage. The battery diagnostic device 100 may diagnose the state of the second switch 142 as normal when the diagnostic voltage is equal to or higher than a second set value. In addition, the battery diagnostic device 100 may diagnose the state of the second switch 142 as a short-circuit failure when the diagnostic voltage is less than the second set value. Here, the second set value may be determined based on at least one of the type of the second switch 142 or the voltage of the battery pack 110.

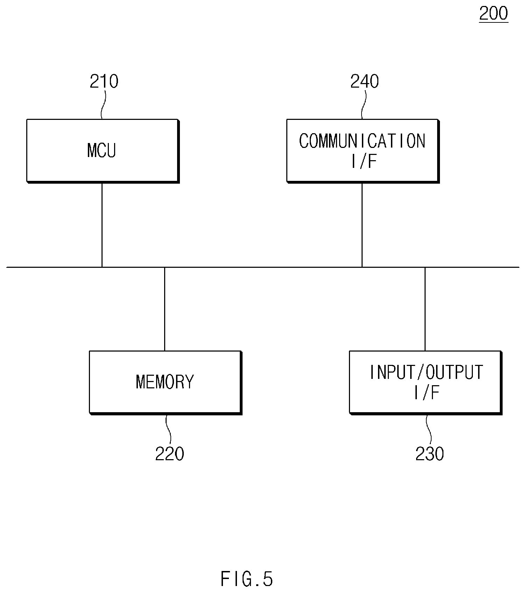

FIG. 5 is a block diagram showing a computing system executing the method of operating a battery diagnostic device according to an embodiment disclosed herein.

Referring to FIG. 5, a computing system 200 according to an embodiment disclosed herein may include a microcontroller unit (MCU) 210, a memory 220, an input/output interface (I/F) 230, and a communication I/F 240.

The MCU 210 may be a processor that executes various programs (e.g., an SOH calculation program, a cell balancing performance target determination program, or the like) stored in the memory 220, processes various data including the SOC, the SOH, and the like of a plurality of battery cells through the programs, and causes the battery diagnostic device 100 described above with reference to FIGS. 1 to 4 to perform the functions.

The memory 220 may store various programs regarding calculating the SOH of a battery cell and determining a target on which to perform cell balancing. In addition, the memory 220 may store various data such as SOC and SOH data of each battery cell.

A plurality of memories 220 may be provided as needed. The memory 220 may be a volatile memory or a non-volatile memory. As the volatile memory, the memory 220 may be a random access memory (RAM), a dynamic RAM (DRAM), a static RAM (SRAM), or the like. For the memory 220 as the non-volatile memory, a read-only memory (ROM), a programmable ROM (PROM), an electrically alterable ROM (EAROM), an erasable programmable ROM (EPROM), an electrically erasable programmable ROM (EEPROM,) a flash memory, or the like may be used. The examples of memories 220 listed above are only exemplary and the computing system is not limited to the examples.

The input/output I/F 230 may provide an interface that enables data to be transmitted and received by connecting an input device (not illustrated) such as a keyboard, mouse, or touch panel, and an output device (not illustrated) such as a display and the MCU 210.

The communication I/F 240 is a component that may transmit and receive various data to and from the server, and may be any device that may support wired or wireless communication. For example, a program for calculating the SOH of a battery cell or determining a balancing target or various data may be transmitted and received from a separately provided external server through the communication I/F 240.

In this way, the method of diagnosing a battery according to an embodiment disclosed herein may be recorded in the memory 220 and executed by the MCU 210.

The above description is merely an example of the technical idea disclosed herein, and those with ordinary skill in the art to which the embodiments disclosed herein belong may make various modifications and variations without departing from the essential characteristics of the embodiments disclosed herein.

Accordingly, the embodiments disclosed herein are not intended to limit the technical ideas disclosed herein but rather to explain them, and the scope of the technical ideas disclosed herein is not limited by these embodiments. The scope of protection disclosed herein should be interpreted by the accompanying claims, and all technical ideas within the scope equivalent thereto should be construed as being included in the scope of rights herein.

## Claims

1. A battery diagnostic device comprising:
a transistor electrically connected to a first charge/discharge line of a battery pack through a first terminal and electrically connected to a second charge/discharge line of the battery pack through a second terminal;
a plurality of base resistors electrically connected to the transistor, the first charge/discharge line and the second charge/discharge line;
a switching unit connected to at least one of the first charge/discharge line or the second charge/discharge line and disposed on a low side; and
a diagnostic unit connected to the switching unit to diagnose a short-circuit failure of the switching unit based on a voltage difference across the switching unit.

2. The battery diagnostic device of claim 1, wherein the switching unit includes a first switch that is a switch for charging and a second switch that is a switch for discharging, and
the diagnostic unit includes a first diagnostic unit connected to the first switch to diagnose a short-circuit failure of the first switch and a second diagnostic unit connected to the second switch to diagnose a short-circuit failure of the second switch, voltages at both ends of the second switch being different from each other.

3. The battery diagnostic device of claim 2, wherein the second diagnostic unit includes an insulating element and a differential amplifier, and
the insulating element is turned on when the second switch is diagnosed to electrically connect the switching unit and the differential amplifier.

4. The battery diagnostic device of claim 3, wherein the differential amplifier is connected to the insulating element and extracts a diagnostic voltage by amplifying the voltage difference across the switching unit when the insulating element is turned on.

5. The battery diagnostic device of claim 2, wherein a first terminal of the second switch is connected to the first switch and a first terminal of the second diagnostic unit, and
a second terminal of the second switch is connected to a charger and a second terminal of the second diagnostic unit.

6. The battery diagnostic device of claim 1, wherein the diagnostic unit diagnoses the switching unit when a state of the switching unit is off.

7. The battery diagnostic device of claim 1, wherein the diagnostic unit is directly connected to the switching unit and diagnoses a short-circuit failure of the switching unit based on a diagnostic voltage defined as a voltage of a connection node between the diagnostic unit and the switching unit.

8. The battery diagnostic device of claim 7, wherein the diagnostic unit diagnoses a short-circuit failure of the switching unit based on a comparison result of the diagnostic voltage and a set value.

9. The battery diagnostic device of claim 8, wherein the set value is set based on a voltage of the battery pack.

10. A method of operating a battery diagnostic device, comprising:
turning off a switching unit connected to at least one of a first charge/discharge line or a second charge/discharge line of a battery pack and disposed on a low side;
acquiring a diagnostic voltage based on a voltage difference across the switching unit; and
diagnosing a short-circuit failure of the switching unit based on a comparison result of the diagnostic voltage and a set value.

11. The method of claim 10, wherein the acquiring of the diagnostic voltage includes turning on an insulating element to electrically connect the switching unit and a differential amplifier.

12. The method of claim 11, wherein the acquiring of the diagnostic voltage includes acquiring the diagnostic voltage by amplifying a voltage difference across the switching unit.

13. The method of claim 10, wherein the diagnosing is diagnosing a state of the switching unit as normal when the diagnostic voltage is equal to or higher than the set value, and diagnosing the state of the switching unit as a short-circuit failure when the diagnostic voltage is less than the set value.

14. The method of claim 13, wherein the set value is set based on a voltage of the battery pack.
